# EUROPEAN PATENT SPECIFICATION

(11) **EP 2 594 061 B1**
(45) Date of publication and mention of the grant of the patent: **02.09.2020**
(21) Application number: 11736141.0
(22) Date of filing: 12.07.2011
(51) Int. Cl.: H04N 5/355, H04N 5/347

(54) **RADIATION DETECTOR AND METHOD**
STRAHLUNGSDETEKTOR UND VERFAHREN
DÉTECTEUR DE RAYONNEMENT ET PROCÉDÉ CORRESPONDANT

(30) Priority: 12.07.2010 GB 201011640
(43) Date of publication of application: 22.05.2013
(73) Proprietor: ISDI Limited, London NW1 9JN (GB)
(72) Inventor: ANAXAGORAS, Thalis, Oxford Oxfordshire OX4 1YZ (GB)
(74) Representative: Yeadon IP Limited
(86) International application number: PCT/GB2011/051300
(87) International publication number: WO 2012/007744

(56) References cited:
- EP-A1- 1 998 559
- EP-A2- 1 435 662
- US-A- 5 714 753
- US-A- 6 043 478
- US-A1- 2006 146 159
- US-B1- 6 809 768

## Description

This invention relates to a radiation detector and a method of detecting radiation, particularly a radiation detector having a pixel. More particularly, the invention relates to a radiation detector with at least two diodes in the pixel for collecting radiation-generated carriers.

### BACKGROUND

Radiation detectors, and particularly image sensing devices that convert incident radiation into an electric signal, are well known and widely used in devices ranging from domestic digital still and movie cameras to medical devices. There is a constant demand for improved functionality and performance. One area in which improved performance is sought is with regard to dynamic range of the sensor; dynamic range describes the range of incident-radiation conditions over which the sensor can operate. It is also desirable for the electric signal from the sensor to have a low noise. Typically, image sensing devices include a plurality of pixels to allow an image to be formed, each pixel normally consisting of a single diode which is employed to collect free carriers (ordinarily electrons) generated by radiation incident on the area corresponding to the pixel. In some sensors, pixel binning is used to increase the signal-to-noise ratio (SNR) at the cost of reduced resolution. Binning is performed by combining the output of neighboring pixels, effectively turning the neighboring pixels into a single super-pixel. However, the SNR of the super-pixel is typically inferior to the SNR that would be achieved by a single pixel of equivalent size. Improved flexibility of image sensing arrays, allowing a single design to be used in varied applications is also desirable.

US 2006/0146159 A1 describes a CMOS active pixel sensor with improved dynamic range. An embodiment uses two separate photodiode detectors within a pixel sensor.

EP 1 998 559 A1 describes an image photographing apparatus with a low-sensitivity sensor and a high-sensitivity sensor.

US 6,809,768 B1 describes a double slope pixel sensor and array. The pixel has first photodiode and a second photodiode which is smaller than the first photodiode.

Embodiments of the invention have the object of addressing one or more of the above shortcomings of the background art.

### BRIEF SUMMARY OF THE DISCLOSURE

In accordance with an aspect of the present invention there is provided a radiation detector according to claim 1 and a method of detecting radiation according to claim 7.

References to embodiments which do not fall under the scope of the claims are to be understood as examples useful for understanding the invention.

This arrangement can provide improved dynamic range and sensitivity.

In an embodiment the first diode and the second diode are arranged such that the first diode collects radiation-generated carriers substantially only after the carriers collected by the second diode exceed the noise floor of the second diode. In some embodiments, the first diode collects radiation-generated carriers substantially only after the carriers collected by the second diode exceed the noise floor of the first diode.

In an embodiment the radiation detector further comprises first bias wiring for applying a first bias voltage to the first diode; second bias wiring for applying a second bias voltage to the second diode, wherein the first and second bias wiring are arranged such that the first and second bias voltages may be different.

In an embodiment the first and second bias wiring are arranged to apply the first and second bias voltages such that the second bias voltage is greater than the first bias voltage.

In an embodiment the second bias wiring is arranged to apply the second bias voltages such that the second diode is prevented from collecting carriers.

In an embodiment the first diode is positioned in a shadow, so as to be at least partially obscured from incident radiation. The shadow may be produced by wiring (routing).

In an embodiment the second diode is provided at a depth within the substrate, and the first diode is provided on the surface of the substrate or within the substrate at a shallower depth than the second diode.

It has been found by the present inventors that in some embodiments it is advantageous to provide the first and second diodes in or on a layer of semiconductor having a higher resistivity, since a depth of the depletion layer increases with resistivity of the layer.

For example, in a semiconductor layer doped with p-type dopant and having a resistivity of around 100 Ωcm the depletion layer depth at a typical potential of 3V has been found to be around 6.1 micrometres. In contrast, in a semiconductor layer doped with p-type dopant and having a resistivity of around 1,000 Ωcm the depletion layer depth at a potential of 3V has been found to be around 19 micrometres.

In some embodiments a semiconductor layer such as a substrate or a layer formed above or within the substrate in which one or more diodes are formed has a resistivity in the range of from around 100 Ωcm to around 1,000 Ωcm, advantageously around 1000Ωcm. In some embodiments the resistivity may be around one selected from amongst 200Ωcm, 300Ωcm, 400Ωcm, 500Ωcm, 600Ωcm, 700Ωcm, 800Ωcm, 900Ωcm or any other suitable value. In an embodiment the pixel includes a plurality of second diodes, the first diode has a higher node capacitance than each of the second diodes, and the switching components operate to permit readout of the first diode independent of each of the second diodes, and readout of each of the second diodes independent of the first diode and the other second diode or diodes. The pixel may have more second diodes than first diodes. A pitch of the first diodes may be greater than a pitch of the second diodes.

In an embodiment the radiation detector includes a plurality of pixels, and the second diode is shared between at least two of the pixels.

In an embodiment the first and second diodes are arranged to collect radiation-generated carriers from respective first and second collection regions, and the first and second regions overlap.

In an embodiment the radiation detector includes a capacitor in parallel with the first diode, the capacitor contributing to the node capacitance of the first diode, wherein the capacitor includes polysilicon. Polysilicon is transparent to visible light, and so making the capacitor using polysilicon allows a high fill factor to be achieved.

In an embodiment the pixel further comprises a third diode, wherein the third diode has a smaller node capacitance than the second diode, and the switching components are operable to permit readout of the third diode independent of each of the first and second diodes.

In an embodiment the pixel includes a plurality of third diodes, the second diode has a higher node capacitance than each of the third diodes, and the switching components operate to permit readout of each of the first and second diodes independent of each of the third diodes, and readout of each of the third diodes independent of each of the first and second diodes and the other third diode or diodes.

In an aspect of the invention a method of detecting radiation comprises providing the radiation detector according to any preceding claim, and detecting radiation using the radiation detector.

In an embodiment the method further comprises defining a region of interest including at least one of the plurality of pixels, but not all of the plurality of pixels, reading out the one or more pixels in the region of interest at a first frequency, reading out one or more pixels not in the region of interest at a second frequency, wherein the first frequency is higher than the second frequency, and the reading out of the pixels in the region of interest uses one of (i) the first diodes in each of the pixels in the region of interest, or (ii) the second diodes in each of the pixels in the region of interest, and the reading out of pixels not in the region of interest uses the other of (i) the first diodes in each of the pixels in the region of interest, or (ii) the second diodes in each of the pixels in the region of interest.

In an embodiment the method further comprises reading out a signal from the second diode, and setting an exposure time based on the signal from the second diode, wherein the detecting radiation is performed using the exposure time.

In an embodiment the radiation detector includes a plurality of the pixels; each pixel has a plurality of the second diodes; and the method further comprises: reading out signals from the pixels, and producing image data based on the signals, wherein the image data has at least one region having a first resolution, based on output from the first diodes, and the image data has at least one region having a second resolution, higher than the first resolution, based on output from the second diodes. According to this embodiment, it is possible to combine regions based on output from the first diodes with regions based on output from the second diodes to produce a high dynamic range image.

In an embodiment the method further comprises applying a bias voltage to the second diode operable to prevent the second diode from collecting carriers.

### BRIEF DESCRIPTION OF THE DRAWINGS

Embodiments of the invention are further described hereinafter with reference to the accompanying drawings, in which:
Figure 1a is a schematic diagram of a conventional 3T pixel.
Figure 1b is a schematic diagram of a conventional 4T pixel.
Figure 2 is a schematic diagram of a pixel according to a first embodiment of the invention.
Figure 3a shows a schematic arrangement of diodes within pixels in an example of the first embodiment.
Figure 3b shows a schematic arrangement of diodes within pixels in another example of the first embodiment.
Figure 4 shows a schematic arrangement of an image sensor in accordance with embodiments of the invention.
Figure 5 is a schematic diagram of a pixel according to a fourth embodiment of the invention.
Figure 6a shows a schematic arrangement of diodes within pixels in an example in accordance with the fourth embodiment, and a schematic representation of an array of the pixels.
Figure 6b shows a schematic arrangement of diodes within pixels in another example in accordance with the fourth embodiment, and a schematic representation of an array of the pixels.
Figure 7 is a schematic diagram of a pixel according to a fifth embodiment of the invention.
Figure 8a is a schematic representation of an arrangement of diodes in a pixel in accordance with the fifth embodiment.
Figure 8b is a schematic representation of an array of the pixels in figure 8a.
Figure 9 schematically shows a cell using four transistors applicable to some embodiments.

### DETAILED DESCRIPTION

The invention is described herein with reference to various embodiments. For the sake of illustration, the embodiments are described with reference to a CMOS image sensor, but the invention is not necessarily limited to a CMOS image sensor. Various embodiments of the invention are described. It would be clear to the skilled man that the features of these embodiments could be combined in various ways without undue experimentation.

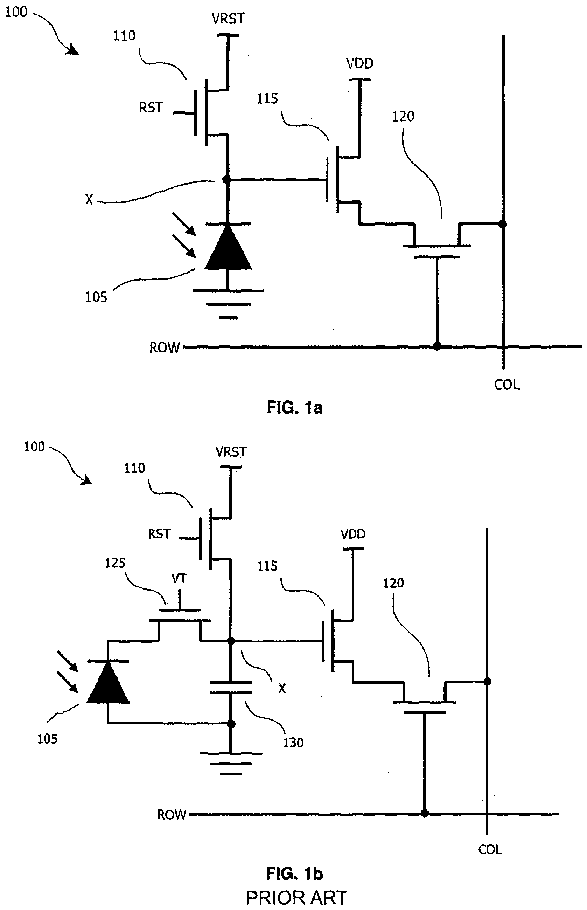

Figure 1a illustrates a known CMOS active pixel 100, known as a 3T active pixel due to the presence of three transistors in the pixel. The pixel includes a diode 105, a reset transistor 110, a source-follower transistor 115 and a selection transistor 120. The diode 105 has one terminal connected to floating node X and the other terminal connected to ground. The source of the reset transistor 110 is connected to the floating node X, the drain of the reset transistor 110 is connected to a supply of potential V_{RST}, and the gate of the reset transistor 110 is supplied with a reset signal RST. The gate, source and drain of the source-follower transistor 115 are respectively connected to the floating node X, the drain of the selection transistor 120, and a supply of reference voltage V_{DD}. The gate of the selection transistor 120 is connected a row line or selection line, and the drain of the selection transistor 120 is connected a column line.

In operation, incident light is absorbed and converted to mobile electron-hole pairs. If the absorption occurs in the depletion region of the diode, or within one diffusion length, the electron-hole pair will be collected by the diode 105, causing a change in the potential at floating node X (while the reset signal RST is OFF). The term photodiode is used herein to describe a diode such as diode 105 that collects photo-generated charge. The potential at node X is applied to the gate of the source-follower transistor 115, and the source-follower transistor 115 acts as an amplifier for the potential at node X. When the pixel is to be read out, the row of the pixel is selected by turning ON the row line ROW, and the amplified signal from the source-follower transistor 115 (the potential at the source of the source-follower transistor 115) is supplied to signal processing electronics via the selection transistor and column line COL.

Periodically, the reset signal RST is turned ON, connecting node X to V_{RST} via the reset transistor 110, removing the accumulated charge on the diode and resetting the potential at node X. Applying V_{RST} to the diode biases the diode, so V_{RST} may be referred to as a bias voltage. V_{RST} may be selected so as to reverse bias the diode to increase the width of the depletion layer and improve response time.

In the arrangement of Figure 1, the potential at floating node X is monotonically dependant on the number of photo-generated electrons collected by the diode, which in turn is monotonically dependant on the level of illumination, specifically the illuminance (the total incident luminous flux, per unit area). When the diode becomes saturated it ceases collection of electrons and the potential at the floating node ceases to change with the level of illumination. Thus, the dynamic range of photodiode depends on the level of illumination at which the diode becomes saturated. The charge collected by the diode before reaching saturation (and hence the level of light that can be measured) depends on the node capacitance of the diode. The larger the node capacitance, the more charge can be collected by the diode, and the greater the dynamic range. However, increasing the node capacitance causes an increase in the sampling noise in the output signal, reducing the Signal-to-Noise Ratio (SNR). Therefore, in the device shown in Figure 1, there is a trade-off between dynamic range and noise.

Figure 1b shows a known active pixel 101 known as a 4T active pixel. In this arrangement, there are four transistors. In addition to the three transistors of the 3T pixel, the 4T pixel includes a transistor 125 that enables the photodiode 105 to be isolated from the floating node X. This arrangement allows Correlated Double Sampling (CDS) to be performed, permitting removal of kTC noise and any fixed pattern noise from the output. In the arrangement of Figure 1a, CDS can be performed by externally subtracting two samples from the pixel: the first sample taken immediately after resetting the pixel, and the second at the end of the exposure (integration period).

The smallest signal that can be detected by the pixel is determined by the noise floor, which is determined by the sum of all the noise sources and unwanted signals. In a typical 3T pixel the dominant noise source is the kTC noise.

### First Embodiment

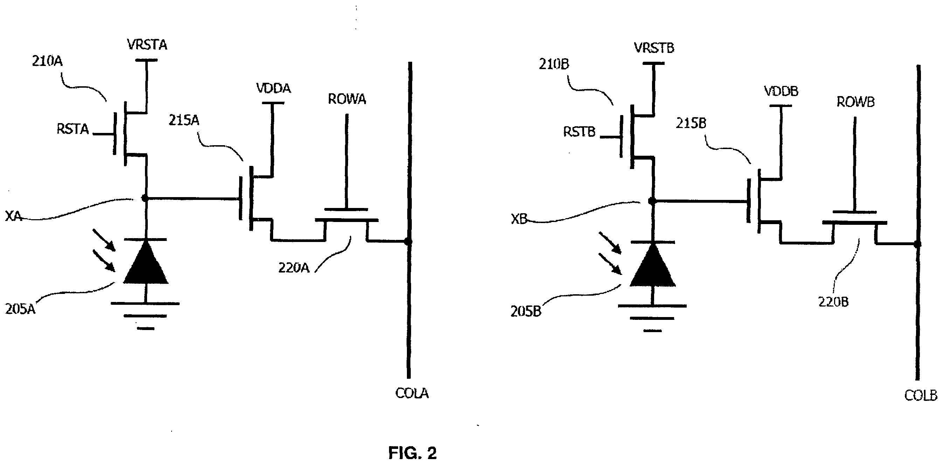

According to a first embodiment of the invention, a pixel is provided with at least two photodiodes, diode A 205A and diode B 205B. An exemplary pixel is illustrated in Figure 2. The arrangement in Figure 2 is similar to that in Figure 1a, except that there are two photodiodes in the pixel of Figure 2, and each photodiode has a corresponding reset transistor 210A and 210B, source-follower transistor 215A and 215B, selection transistor 220A and 220B, and connections to voltage/signal sources and signal lines. Diode A 205A has a larger node capacitance than diode B 205B. Diodes A and B are arranged such that the switching components (in this case selection transistors 220A and 220B) are arranged such that diodes A and B can be independently read out. That is, the amplified signals from the source-follower transistors 215A and 215B representative of the number of photoelectrons collected respectively by the A and B diodes is supplied to column lines in a way that allows the amplified signals to be evaluated separately and/or at times independent of evaluation of the other signal (i.e. at different frequencies or exposure times).

According to some examples, diodes A and B would ideally be arranged such that diode A 205A collects photo-generated electrons only after diode B 205B is saturated. Practically, in such embodiments, it is likely that diode A 205A will collect some photo-generated electrons before diode B 205B is saturated, and as diode B 205B nears saturation it is more likely that diode A 205A will collect photo-generated electrons. Accordingly, diode A 205A and diode B 205B may be arranged such that diode A 205A substantially only collects photo-generated electrons after (while) diode B 205B is substantially saturated. Diode A 205A and diode B205B may be arranged such that initially (e.g. following a reset of the nodes XA and XB to V_{DD}), diode B 205B is more likely to collect photo-generated electrons than diode A 205A, and diode A 205A is more likely to collect photo-generated electrons as the number of photo-generated electrons collected by diode B 205B increases, and particularly as diode B 205B reaches or nears saturation. In some examples diode A collects photoelectrons substantially only after diode B has collected carriers sufficient to exceed the noise floor of diode B. Preferably the collection by diode A would only follow collection by diode B equivalent to several times the noise floor of diode B. For example the number of collected electrons is twice or three times the number at the noise floor. According to these conditions, the B diode 205B initially collects preferentially (relative to the A diode 205A). Here initially refers to the period immediately following a reset of the A and B diodes.

Other examples may be arranged such that the A diode and B diode both collect photo-generated electrons initially after a reset. In this case, if diode B becomes saturated, diode A will continue to collect photo-generated electrons.

According to the present embodiment, when low levels of illumination are incident on the pixel, diode B 205B collects the majority of the photo-generated electrons without reaching saturation. At low levels of illumination, sampling noise (kTC noise or thermal noise) is significant. The sampling noise is dependent on the node capacitance, and because of the relatively small node capacitance of diode B 205B, the corresponding (RMS) sampling noise is relatively small, and a signal read out from the column COLB via selection transistor 220B has a high SNR.

When the illumination incident on the pixel is sufficient to saturate diode B 205B, diode A 205A will also collect photo electrons. Accordingly, at or before saturation of diode B, a useable signal can be obtained from diode A 205A, effectively extending the dynamic range. The increased sampling noise associated with the higher node capacitance of the A diode 205A relative to diode B 204B is offset by the increased signal (read out from COLA via selection transistor 220A) associated with the level of illumination sufficient to saturate diode B 205B.

The present embodiment may be arranged such that diode A is arranged to collect photo-generated electrons when shot noise is the dominant source of noise. In this case, the node capacitance of the A diode does not affect the dominant source of noise.

By using the signal from COLB when diode B 205B is not saturated, and using the signal from COLA when diode B 205B is saturated, it is possible to achieve a high SNR at low levels of illumination associated with the relatively small node capacitance of the B diode 205B, while also having the relatively large dynamic range associated with the relatively high node capacitance of the A diode 205A. Various criteria can be used to determine whether the signal from COLA or the signal from COLB is to be used. For example, if the photo-generated electrons collected by diode A exceeds a predetermined threshold. The threshold could alternatively be set with respect to diode B.

In some embodiments the signal from the diode 205A, 205B having the higher potential at its respective node X is used. This is because the B diode 205B will collect charge until it reaches the potential of the A diode 205A, after which time they will both collect charge. With suitable circuitry, it is possible to read only the diode with the greater voltage and so effectively increase the overall dynamic range of the sensor.

Some examples may be arranged so as to use the B diode 205B with a long exposure time when low levels of illumination are incident on the pixel, and to use the A diode 205A with a short exposure time when high levels of illumination are incident on the pixel.

The regions from which diodes A 205A and B 205B collect photo-generated electrons may at least partially overlap. In some embodiments, the regions from which A diodes 205A collect photo-generated electrons are substantially entirely overlapped by regions from which B diodes 205B collect photo-generated electrons. In some embodiments, the regions from which B diodes 205B collect photo-generated electrons are substantially entirely overlapped by regions from which A diodes 205A collect photo-generated electrons.

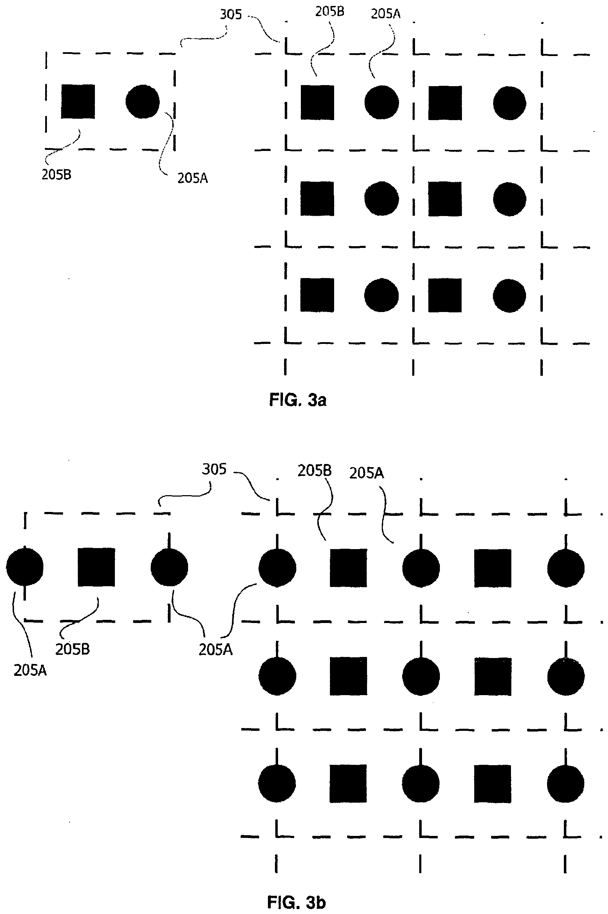

The sensor preferably has a plurality of pixels 100 arranged in columns and rows. Figures 3a and 3b each show a schematic example of the layout of an individual pixel 100 and an array of pixels. Diodes A 205A and B 205B are shown respectively by filled circles and squares, and pixel boundaries 305 are shown by dashed lines. In figure 3a, diodes A 205A and B 205B are both contained wholly within the pixel boundary 305. In contrast, in figure 3b, diode B 205B is entirely within the pixel boundary 305, and two A diodes 205A are each half inside the pixel boundary 305 so that each A diode is shared between pairs of pixels. Other arrangements of the diodes within the pixel 100 are also possible. The definition of the pixel boundary may be significant when designing the control and readout electronics, and when grouping A and B diodes for the purpose of deriving an image from the output signals, for example. The pixels do not need to be identical. The arrangement of diodes does not need to be the same in each pixel. In some pixels, the A diode 205A and/or B diode 205B may be replaced by an A' diode or a B' diode, where the A' and B' diodes operate in the same manner as the A and B diodes, respectively, but have different node capacitances.

According to the present embodiment, diodes A and B have separate column and row lines, as can be seen in Figure 2. This allows the A diode 205A to be addressed and read independently of the B diode 205B. The A and B diodes can also be reset independently. By analogy with the diode 105 of Figure 1, each of diodes A 205A and B 205B can be reset with a respective reset signal (V_{RST}A, V_{RST}B), and selected with a respective select signal on respective row line (ROWA, ROWB). When selected, an output signal for each diode is supplied to a respective column line (COLA, COLB). Herein, reset means applying a bias voltage to a diode (connecting a diode to a supply of a bias voltage), removing charge accumulated on the diode.

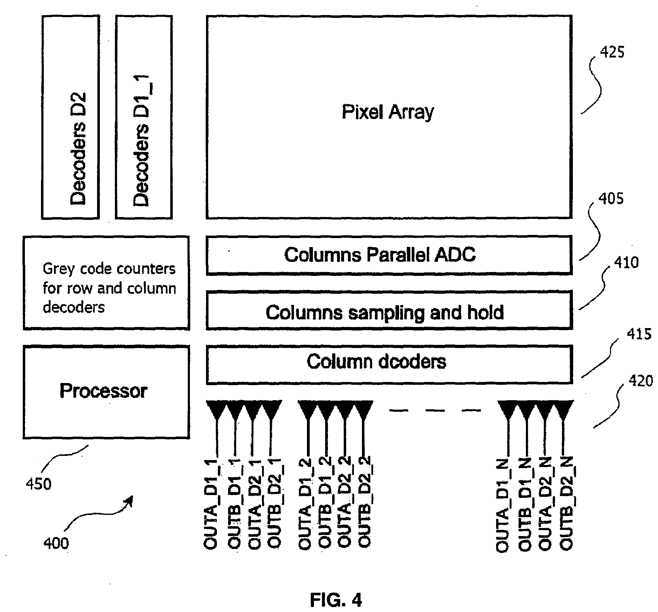

Figure 4 shows a schematic block diagram of an imager 400 for use with the current embodiment. A plurality of pixels are provided in the pixel array 425. Row decoders are provided to apply a selection signal to the row lines ROWA, ROWB. One decoder may be arranged to select row lines associated with the A diodes 205A, while another decoder may be arranged to select row lines associated with the B diodes 205B. The column lines COLA, COLB are connected to a column Analogue to Digital Converter (ADC) 405 to convert the analogue signal on the column lines COLA, COLB to a digital signal. The digital signal may then be passed to a sample and hold circuit 410, column decoders 415 and signal processing circuitry 420, such as operational amplifiers. Preferably, the column ADC is a column parallel ADC. Exemplary, non-limiting, sensor arrays 425 may have between 1280 and 2560 rows of pixies, and between 1280 and 2560 columns of pixels. The pixels may have a pixel pitch of about 40µm or greater and about 100µm or less (preferably around 50µm or less) in each of the row and column directions. The imager 400 may be read out in a rolling shutter mode. Other arrangements are possible; for example, the ADC and other signal processing components could be provided separately.

Where the A diodes are selected by a different decoder from the B diodes, the A and B diodes may form independent and overlapping pixel arrays that can be operated independently of each other (in terms of addressing and reading out, etc.)

The imager may include a processor 450 to control the components of the imager and/or process signals from the pixel array.

In some examples the imager can be arranged to perform Correlated Double Sampling (CDS). This can be achieved by resetting the diode and then reading the reset value, or by non-destructive readout during exposure and subtracting the frames. CDS allows sampling noise to be subtracted and Fixed Pattern Noise (FPN) to be removed. CDS and subtraction/removal of noise may be performed externally by processor 450. By using pin-diodes (4T pixels) CDS may be performed without destructive readouts or external image processing.

The pixel of the present embodiment can be produced using conventional CMOS production techniques, which are well documented. Other production techniques could also be used. The difference in node capacitance between the A diode 205A and the B diode 205B can be produced by making the A and B diodes of different physical sizes. Preferably, however, a supplementary capacitor is provided in parallel with one or each of the A and B diodes to increase the associated node capacitance. The capacitor can be produced using standard CMOS techniques. Polysilicon may be used to build the capacitance; as polysilicon is transparent to visible light, the fill factor with respect to visible light will not be reduced by this capacitor.

Table 1 shows exemplary parameters and expected levels of noise for the A and B diodes. According to this example, CDS is performed externally for the signal from the B diode 205B (the signal supplied via COLB). In this example, CDS is not necessary for the signal from the A diode as the signal from the A diode will be dominated by shot noise.

**Table 1**

| | Diode A | Diode B |
|---|---|---|
| Diode Node Capacitance | 50 fF-100 fF | 10 fF |
| Full Well | 374K or 749K | 70K |
| Noise | 90-125 e⁻ rms | 40 e⁻ rms |
| Noise after CDS | N/A | 12.5 e⁻ rms |

According to the present embodiment, the reset voltage, or bias voltage, V_{RST}A applied to the A diode 205A via the reset transistor 210A is different from the reset (bias) voltage V_{RST}B applied to the B diode 205B. In the present case, V_{RST}B is greater than V_{RST}A. Because of this, after resetting the A and B diodes, the B diode 205B has a larger depletion region and is more likely to collect photo-generated electrons than the A diode 205A. As the B diode 205B collects electrons, and eventually becomes saturated, the likelihood of photo-generated electrons being collected by the A diode 205A increases.

As noted above, the use of semiconductor materials having relatively high resistivity is advantageous in some embodiments in allowing the depletion region to be increased in depth.

According to some examples of the present embodiment, the B diode 205B preferentially collects photo-generated electrons at the start of a frame (after a reset of the diodes). That is, after a reset, the A and B diodes do not initially collect photo-generated electrons at the same time; the A and B diodes collect photo-generated electrons substantially sequentially.

When a pixel in accordance with this embodiment is read out the signal from the B diode 205B may be used when the B diode 205B is not saturated, and the signal from the A diode 205A may be used when the B diode 205B is saturated. In some examples signals from both A and B diodes are read out for each pixel, and it is subsequently determined which signal to use for each pixel. In other examples, only the diode to be used in each pixel is read out. The determination of which signals are to be used may be performed by the processor 450.

According to the present embodiment, the B diode 205B can be used for dose sensing to set an exposure for the detector. One or more B diodes 205B are selectively addressed and read quickly (relatively quickly compared to a normal frame duration). Based on this, the intensity of light can be estimated, and the frame rate or frame duration (exposure time) can be set accordingly.

In some examples, a pixel array can be arranged to use A diodes 205A in a first region of the array and B diodes 205B in a second region of the array. For example, in a case where one part of the array receives relatively high levels of incident light and another part of the array receives relatively low levels of incident light, the signal from the A diodes 205A is used where higher levels of incident light are received (the first region) and the signals from B diodes 205B is used where lower levels of incident light are received (the second region). The first and second regions may be determined by the processor 450 based on the levels of light incident on the regions of the pixel array. A plurality of first and/or second regions could be used. In some examples, all A and B diodes are read out, and subsequent processing is used to determine whether the signal from A or B diode will be used. In other examples, only the diodes to be used are read out. This could be based on a previous determination of which diodes to use, for example based on output from a previous frame or based on some other dose sensing. Determination of the first and second regions and the selection of A or B diode may be controlled by processor 450, and may be based on a comparison with a detected level of light against values in a look-up table, for example.

As the A and B diodes are individually addressable, it is possible to read out the A and B diodes at different rates (frame rates), and so the first and second regions can be read out at respective first and second rates, improving flexibility.

The decoders may be arranged so that certain sequential pixels (sequential addresses) can be addressed (selected) without addressing the entire array. This would allow readout of a selected rectangular region of interest (ROI) without reading out the entire array, so it is possible for one decoder to concentrate on specific rows, giving faster readout of the ROI (relative to when the entire array is addressed). The other decoder may continue to read out all of the rows, giving a slower readout of the pixel array outside the ROI. The signals from A diodes 205A may be used for the ROI when the ROI is relatively bright. On the other hand, the B diodes may be used for the ROI when the ROI is relatively dark. Multiple regions of interest can be defined, in which either destructive or non-destructive readout may be performed.

### Second Embodiment

The second embodiment is similar to the first embodiment in that the pixels are arranged as shown in Figure 2.

According to the second embodiment, the A diode 205 is positioned in a shadow, so that at least part of diode A 205A is hidden or obscured from incident light. In some embodiments, the A diode 205A is completely within a shadow.

As the amount of incident light falling directly on the A diode 205A is reduced by the shadow, the A diode is less likely to collect photo-generated electrons, and the initial rate of collection by the A diode 205A is low or is reduced relative to the case where the A diode 205A is not obscured. On the other hand, the B diode 205B is not obscured (or is relatively unobscured), and so the initial rate of collection of photo-generated electrons by the B diode 205B is greater than that of the A diode 205A. Here 'initial' refers to the state just after the diodes have been reset.

If the incident light has a sufficiently high level, the B diode 205B will become saturated. As the B diode 205B reaches (or nears) saturation, excess free electrons generated by the incident light will be collected by the A diode 205A. Thus, as with the first embodiment, the B diode 205B initially collects photo-generated electrons, and can provide a signal with a high SNR when it is not saturated by the level of illumination. If the B diode becomes saturated (or nears saturation), the A diode will collect excess photo-generated electrons, and the signal from the A diode 205A will be representative of the incident light level provided the A diode 205A does not also reach saturation.

The second embodiment can be implemented with the same bias voltage on each of the A and B diodes (V_{RST}A=V_{RST}B). In alternative implementations, the A and B diodes can have different bias voltages, as in the first embodiment. When the reset voltage of the B diode 205B is set to be greater than the reset voltage of the A diode 205A, shadow and bias voltages both contribute to causing B diode 205B to initially collect preferentially.

In some examples of the present embodiment, diode A 205A is positioned in a wiring shadow. The shadow may be produced by row lines or column lines.

### Third Embodiment

The third embodiment is similar to the first embodiment in that the pixels are arranged as shown in Figure 2.

According to the third embodiment, at least one of the A and B diodes is provided within the substrate. According to preferred examples, the B diode 205B is implanted within the substrate and the A diode 205A is provided on the surface of the substrate or within the substrate at a shallower depth than the B diode 205B. With this arrangement, the B diode 205B is more likely to collect photo-electrons than the A diode 205A initially (after a reset).

The third embodiment can be implemented with the same bias voltage on each of the A and B diodes (V_{RST}A=V_{RST}B). In alternative implementations, the A and B diodes can have different bias voltages, as in the first embodiment. When the reset voltage of the B diode 205B is set to be greater than the reset voltage of the A diode 205A, the relative depth of the B diode within the substrate and larger bias voltage on the B diode both contribute to causing the B diode 205B to initially collect preferentially.

In some examples of the third embodiment, the A diode 205A may be at least partially obscured from incident light, similar to the second embodiment.

### Fourth Embodiment

According to the fourth embodiment, the pixel includes an A diode 205A and more than one B diode 205Bi (205Bi is a general reference to one or more of the B diodes). Similar to the first to third embodiments, the A diode 205A has a greater node capacitance than each of the B diodes 205Bi. The B diodes 205Bi may be arranged so as to preferentially collect photo-generated electrons initially after a reset. According to this embodiment, it is preferable that there are more B diodes 205Bi than A diodes 205A in each pixel.

In some examples the A and B diodes have different pitches. Preferably the A diodes 205A have a larger pitch (e.g. 100 µm) than the B diodes 205B (e.g 50 µm). Accordingly, by using only the A diodes 205A or only the B diodes 205B the same pixel array can be used in applications requiring different detector pitches.

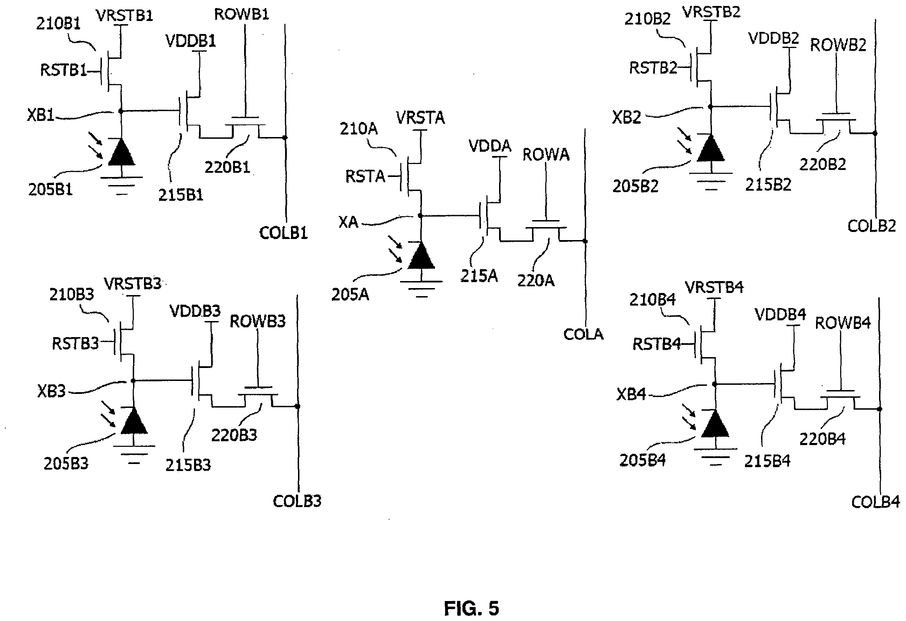

Figure 5 is a schematic representation of a pixel arrangement according to the present embodiment. The pixel of Figure 5 includes four B diodes 205B1, 205B2, 205B3, 205B4, and one A diode 205A. According to this embodiment, each of the four B diodes has essentially the same node capacitance and essentially the same reset voltage V_{RST}B1, V_{RST}B2, V_{RST}B3, V_{RST}B4 is applied to each of the B diodes. The reference signs in Figure 5 correspond to those of Figure 2, with the digit 1, 2, 3 or 4 appended for components associated with the respective first to fourth B diodes. The components of Figure 5 correspond to those described in relation to figure 2 in the first and second embodiments, and have corresponding properties.

Each of the diodes in Figure 5 can be addressed, read out and reset independently.

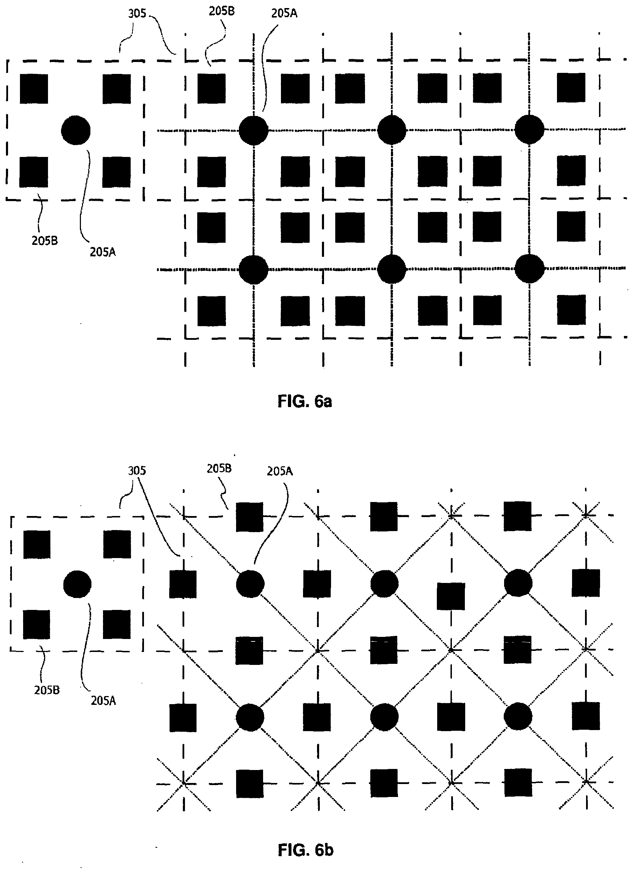

Figures 6a and 6b each show schematic examples of the layout of an individual pixel 100 and an array of pixels according to this embodiment. Diodes A 205A and B 205Bi are shown respectively by filled circles and squares, and pixel boundaries 305 are shown by dashed lines. A sub-pixel is associated with each of the B diodes 205Bi; the sub-pixel boundary is shown as a dotted line.

In Figure 6a, four B diodes 205B1-205B4 and one A diode 205A are contained wholly within the pixel boundary 305. In this example there are four B diodes 205Bi for each A diode 205A, and the sub-pixel boundary partially coincides with the pixel boundary.

In the arrangement of Figure 6b, diode A 205A is entirely within the pixel boundary 305, and four B diodes 205Bi are each half inside the pixel boundary 305. In this arrangement there are two B diodes 205Bi for each A diode 205A.

The B diodes 205Bi may have a pitch of around 40 µm to around 50 µm, and the A diodes may have a pitch around 80 µm to around 100 µm.

Other arrangements of the diodes within the pixel 100 are also possible. The ratio of B diodes 205Bi to A diodes 205A is not particularly limited.

As described in relation to the first embodiment, one or more of the B diodes 205Bi may be used for dose sensing. According to this embodiment one or more B diodes 205Bi in a pixel may be used for dose sensing. In embodiments with a plurality of pixels, one or more B diodes 205Bi in each of one or more pixels may be used for dose sensing.

By providing a pixel with different numbers of A and B diodes, it is possible to implement binning. According to examples of the present embodiment, the signal from the A diode 205A can be used as a binned combination of the B diodes 205Bi in the same pixel. In this case, the sub-pixels associated with the B diodes 205Bi are acting as the pixels to be binned, and the pixel associated with the A diode 205A is acting as the binned super-pixel. In some examples, where the B diodes are on a pixel boundary and shared between adjacent pixels (as in Figure 6b, for example), this sharing should be taken into account in determining the correspondence between the sub-pixels associated with B diodes 205Bi and the pixels associated with A diodes 205A. In some examples, it is possible to use binning for some pixels in the pixel array while not using binning for the other pixels. This allows regions with different resolutions and different SNR and different dynamic range.

The pixel array may be arranged such that, where the signal from the A diode is to be used and the signals from the B diodes are not required, the reset potential V_{RST}Bi supplied to the B diodes is set to forward bias to the B diodes, effectively "turning off" the B diode, preventing (or reducing) collection of photo-electrons by the B diodes 205B. The B diodes 205B could also be unbiased (0V bias). The pixel array can be arranged so that the bias applied to the pixels can be switched between reverse bias, no bias and forward bias, so photodiodes can effectively be turned on and off.

### Fifth Embodiment

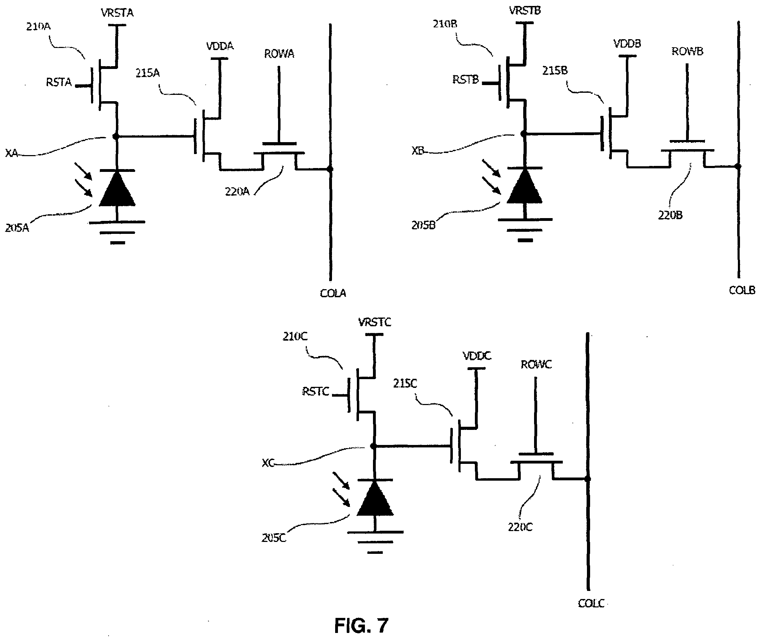

The fifth embodiment has a pixel similar to the pixels described in relation to the first to fourth embodiments, but additionally has at least one C diode 205C. Each C diode is connected to a reset transistor 210C, source-follower transistor 215C and a selection transistor 220C, corresponding to the components connected to the A and B diodes, described in relation to the first to fourth embodiments. RSTC, V_{RST}C, V_{DD}C, ROWC and COLC are equivalent to the corresponding elements of the first to fourth embodiments. Figure 7 shows a schematic diagram of a pixel having one A diode 205A, one B diode 205B and one C diode 205C.

The diode C 205C has a smaller node capacitance than the diode B 205B. The diodes may be arranged so that diode C 205C will initially preferentially collect photo-generated electrons (relative to diode B 205B and diode A 205A). By analogy with the first embodiment, V_{RST}C may be greater than V_{RST}B. Alternatively, or in addition, the diodes may be arranged so that diode B 205B is partially or entirely obscured from incident light, e.g. by being placed in a shadow of wiring, similar to the second embodiment. As a further alternative, or additionally, the C diode 205C may be provided within the substrate at a greater depth than each of the A and B diodes, by analogy with the third embodiment.

The pixel includes one or more B diodes 205B, and one or more C diodes 205Ci, and preferably includes more C diodes 205Ci than B diodes 205B, and more B diodes 205Bi than A diodes 205A.

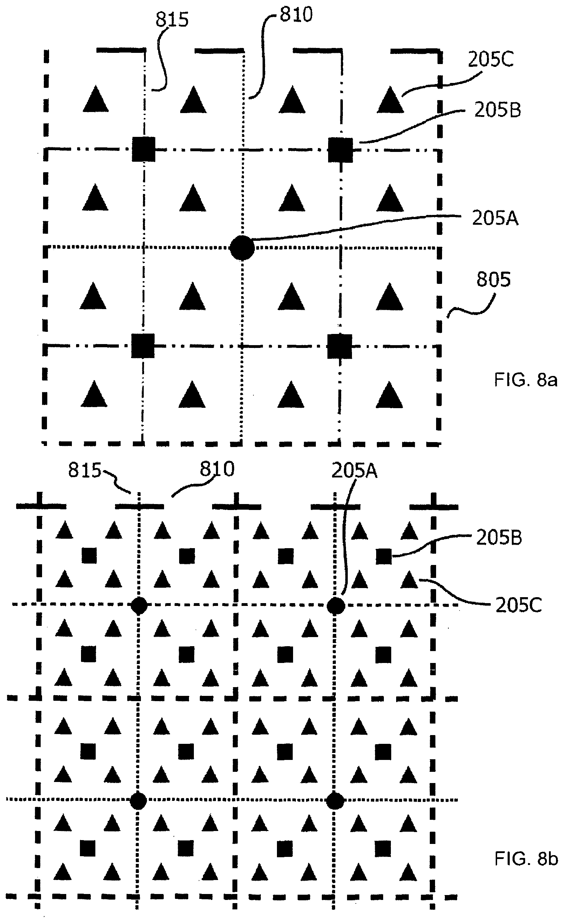

Figures 8a and 8b show an exemplary arrangement of the diodes according to the present embodiment. Figure 8a shows an individual pixel and figure 8b shows an array of the pixels of Figure 8a. A, B and C diodes are represented by filled circles, squares and triangles, respectively. Pixel boundaries 805 associated with the A diodes are shown by dashed lines and sub-pixel boundaries 810 associated with the B diodes are shown as dotted lines. Sub-sub-pixel boundaries 820 associated with the C diodes 205C are shown as dot-dot-dash lines in Figure 8a, and are not shown in Figure 8b for clarity. According to the arrangement of figures 8a and 8b, there are four B-diodes for each A diode 205A, and four C diodes 205C for each B diode 205B. Other arrangements of A, B and C diodes are possible.

By including A, B and C diodes, the present embodiment allows for an increased dynamic range and/or improved SNR, relative to an equivalent arrangement with only A and B diodes. The C diodes 205C can be arranged to produce a low-illumination signal with a high SNR (relative to the signal that would be produced by the A or B diodes under the same illumination), improving sensitivity, while the A diode can be arranged to have a high node capacitance, increasing the level of light that can be detected before saturation of the pixel as a whole is reached. The B diode 205B can be arranged to provide an intermediate level, having lower sampling noise than the A diode 205A, but able to detect higher levels of illumination than the C diode 205C before reaching saturation.

In some examples, binning can be performed at the level of B diodes 205B (replacing sub-sub pixels associated with C diodes 205Ci with sub-pixels associated with B diodes 205Bi) or A diodes 205A (replacing sub-pixels associated with B diodes 205Bi with pixels associated with A diodes 205A), improving flexibility. Similarly a ROI can be imaged using A diodes 205A, B diodes 205B or C diodes 205C, improving flexibility.

The fifth embodiment has three sets of diodes, A, B and C, the diodes of each set having the same node capacitance as other diodes in the same set, and different node capacitances from diodes in the other sets. Additional sets of diodes could be provided, such as a set of D diodes having a smaller node capacitance than the C diodes. Preferably each pixel will have more diodes with a lower capacitance than diodes with a higher capacitance. For example, there are preferably more B diodes than A diodes in each pixel.

### Other Embodiments

The first to fifth embodiments were produced using CMOS technology. However, this is not limiting, and Silicon on Insulator (SOI) technology could be used in place of CMOS technology, for example.

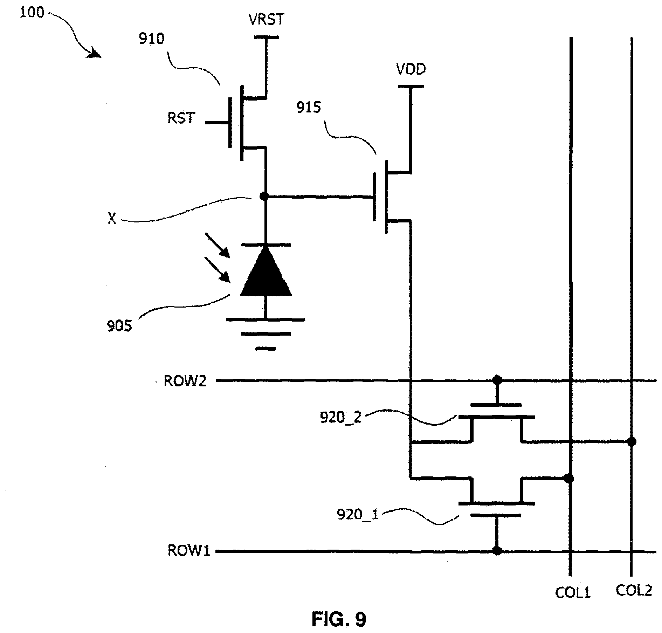

The exemplary embodiments use a 3T arrangement, having three transistors associated with each photodiode. Other arrangements could be used, such as an arrangement with four transistors associated with each photodiode (a 4T cell). In one example, a 4T cell as shown in Figure 1b is used. In another example, the arrangement of Figure 9 is used. The arrangement of Figure 9 is a pixel with two column outputs to enable an increased frame rate and to permit non-destructive readouts. This arrangement has two readouts, allowing independent, simultaneous readout of multiple rows/columns. In particular, different groups of diodes can be read out with differing frequencies, allowing for variable exposure.

The exemplary embodiments include a single A diode 205A in each pixel, but more than one A diode 205A could be used in each pixel.

It is to be understood that a level of performance of a pixel or pixel array according to embodiments of the invention may be dependent on a layout of components and wiring of the pixel or array, and in particular the diodes. Performance can be defined in terms of one or more of the following measures - signal to noise ratio, dynamic range and/or one or more other parameters that may characterise a pixel or pixel array for a particular application.

It is found that in some embodiments performance may be enhanced by placing the diodes (A diodes, B diodes and one or more of any other diode or diodes that may be present such as C and/or D diodes) as close together as possible. For example, in some embodiments one or more diodes are formed to encircle or enclose one or more other diodes. For example, two or more diodes may be arranged in a doughnut arrangement or other arrangement in which one diode encircles another.

This feature has the advantage that the different types of diode may be arranged to have depletion regions that overlap one another. The arrangement may be such as to give priority (advantage) to the higher sensitivity diode (diode of higher gain) to collect the first carriers generated by incident radiation following a reset of the pixel.

Thus, in some embodiments, one diode arranged to have higher gain and higher SNR at relatively low values of incident radiation flux intensity may be arranged to encircle a diode of lower gain and lower SNR at the relatively low values of incident flux. The diode of higher gain and higher SNR at the lower values of incident flux may be arranged to occupy a larger area and therefore be exposed to a higher quantity of incident radiation for a given radiation flux intensity. It is to be understood that the diode of lower gain will exhibit higher SNR at higher incident flux intensities.

Other arrangements are also useful.

The embodiments have been described with reference to photo-electrons, which are free electrons excited into the conduction band by photons of incident light. The incident light is not limited to visible light, and could also be Infrared, X-rays, gamma-rays or electromagnetic radiation of other frequencies able to generate free electrons. Other ionizing radiation can also generate free electrons, and the embodiments described herein can be applied more generally as radiation detectors. A free electron generated by incident radiation is referred to herein as a radiation-generated electron, where the radiation could be any radiation suitable for generating free electrons, such as electromagnetic radiation, or energetic particles.

Embodiments of the present invention can be used in scintillation radiation detectors. In this case, a scintillator converts incident radiation to electromagnetic radiation (normally visible light), and the converted electromagnetic radiation is detected by the radiation detector of the embodiment.

The embodiments have been described as having diodes that collect photo-generated (or radiation-generated) electrons. However, other radiation-generated free charge carriers (referred to as "carriers" herein), such as holes, may be collected by the diodes.

The functions described herein as provided by individual components could, where appropriate, be provided by a combination of components instead. Similarly, functions described as provided by a combination of components could, where appropriate, be provided by a single component.

Throughout the description and claims of this specification, the words "comprise" and "contain" and variations of them mean "including but not limited to", and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics, compounds, chemical moieties or groups described in conjunction with a particular aspect, embodiment or example of the invention are to be understood to be applicable to any other aspect, embodiment or example described herein unless incompatible therewith. All of the features disclosed in this specification (including any accompanying claims, abstract and drawings), and/or all of the steps of any method or process so disclosed, may be combined in any combination, except combinations where at least some of such features and/or steps are mutually exclusive. The invention is not restricted to the details of any foregoing embodiments. The invention extends to any novel one, or any novel combination, of the features disclosed in this specification (including any accompanying claims, abstract and drawings), or to any novel one, or any novel combination, of the steps of any method or process so disclosed.

The reader's attention is directed to all papers and documents which are filed concurrently with or previous to this specification in connection with this application and which are open to public inspection with this specification.

## Claims

1. A radiation detector comprising a pixel, the pixel having:
a first diode (205A) arranged to collect radiation-generated carriers from a first collection region;
a second diode (205B) arranged to collect radiation-generated carriers from a second collection region, wherein the first diode (205A) has a higher node capacitance than the second diode (205B);
switching components (220A, 220B) operable to permit independent readout of signals from the first diode (205A) and the second diode (205B);
first bias wiring for applying a first bias voltage (VRSTA) to the first diode (205A);
second bias wiring for applying a second bias voltage (VRSTB) to the second diode (205B),
**characterised in that** the first collection region and the second collection region at least partially overlap or entirely overlap, and
the first and second bias wiring are arranged to apply the first bias voltage (VRSTA) to reset the first diode (205A) and to apply the second bias voltage (VRSTB) to reset the second diode (205B), wherein collection of radiation-generated carriers by the first diode (205A) begins after resetting the first diode (205A) and collection of radiation-generated carriers by the second diode (205B) begins after resetting the second diode (205B), wherein the first and second bias voltages (VRSTA, VRSTB) are different, with the second bias voltage (VRSTB) greater than the first bias voltage (VRSTA).

2. The radiation detector according to claim 1, wherein:
the pixel includes a plurality of second diodes (205B),
the first diode (205A) has a higher node capacitance than each of the second diodes (205B), and
the switching components operate to permit readout of the first diode (205A) independent of each of the second diodes (205B), and readout of each of the second diodes (205B) independent of the first diode (205A) and the other second diode or diodes (205B).

3. The radiation detector according to claim 2, wherein the pixel has more second diodes (205B) than first diodes (205A).

4. The radiation detector according to any preceding claim, including a capacitor in parallel with the first diode (205A), the capacitor contributing to the node capacitance of the first diode (205A), wherein the capacitor includes polysilicon.

5. The radiation detector according to any preceding claim, wherein the pixel further comprises a third diode (205C), wherein
the third diode (205C) has a smaller node capacitance than the second diode (205B),
and a third bias wiring for applying a third bias voltage (VRSTC) to the third diode (205C), to reset the third diode (205C), wherein the third bias voltage (VRSTC) is greater than the second bias voltage (VRSTB); and
the switching components are operable to permit readout of the third diode independent of each of the first and second diodes (205A, 205B).

6. The radiation detector according to claim 5, wherein:
the pixel includes a plurality of third diodes,
the second diode has a higher node capacitance than each of the third diodes, and
the switching components operate to permit readout of each of the first and second diodes independent of each of the third diodes, and readout of each of the third diodes independent of each of the first and second diodes and the other third diode or diodes.

7. A method of detecting radiation, the method comprising:
providing the radiation detector according to any preceding claim, and
detecting radiation using the radiation detector, the method further comprising applying a bias voltage (VRSTA) to the first diode (205A) to reset the first diode (205A) and applying a bias voltage (VRSTB) to the second diode (205B) to reset the second diode (205B), wherein collection of radiation-generated carriers by the first diode (205A) and the second diode (205B) begins after resetting the first diode (205A) and the second diode (205B), **characterised in that** the second bias voltage (VRSTB) is greater than the first bias voltage (VRSTA).

## Patentansprüche

1. Strahlungsdetektor, der ein Pixel umfasst, wobei das Pixel Folgendes beinhaltet:
eine erste Diode (205A), ausgelegt zum Sammeln von strahlungserzeugten Trägern von einer ersten Sammelregion;
eine zweite Diode (205B), ausgelegt zum Sammeln von strahlungserzeugten Trägern von einer zweiten Sammelregion, wobei die erste Diode (205A) eine höhere Knotenkapazität hat als die zweite Diode (205B);
Schaltkomponenten (220A, 220B) mit der Aufgabe, ein unabhängiges Ablesen von Signalen von der ersten Diode (205A) und der zweiten Diode (205B) zuzulassen;
erste Vorspannungsverdrahtung zum Anlegen einer ersten Vorspannung (VRSTA) an die erste Diode (205A);
zweite Vorspannungsverdrahtung zum Anlegen einer zweiten Vorspannung (VRSTB) an die zweite Diode (205B),
**dadurch gekennzeichnet, dass** die erste Sammelregion und die zweite Sammelregion wenigstens teilweise oder vollständig überlappen, und
die erste und die zweite Vorspannungsverdrahtung zum Anlegen der ersten Vorspannung (VRSTA) zum Zurücksetzen der ersten Diode (205A) und zum Anlegen der zweiten Vorspannung (VRSTB) zum Zurücksetzen der zweiten Diode (205B) ausgelegt sind, wobei das Sammeln von strahlungserzeugten Trägern durch die erste Diode (205A) nach dem Zurücksetzen der ersten Diode (205A) beginnt und das Sammeln von strahlungserzeugten Trägern durch die zweite Diode (205B) nach dem Zurücksetzen der zweiten Diode (205B) beginnt, wobei die erste und die zweite Vorspannung (VRSTA, VRSTB) unterschiedlich sind, wobei die zweite Vorspannung (VRSTB) größer ist als die erste Vorspannung (VRSTA).

2. Strahlungsdetektor nach Anspruch 1, wobei:
das Pixel mehrere zweite Dioden (205B) beinhaltet,
die erste Diode (205A) eine höhere Knotenkapazität hat als jede der zweiten Dioden (205B), und
die Schaltkomponenten die Aufgabe haben, das Ablesen der ersten Diode (205A) unabhängig von jeder der zweiten Dioden (205B) und das Ablesen von jeder der zweiten Dioden (205B) unabhängig von der ersten Diode (205A) und der zweiten Diode oder Dioden (205B) zuzulassen.

3. Strahlungsdetektor nach Anspruch 2, wobei das Pixel mehr zweite Dioden (205B) als erste Dioden (205A) hat.

4. Strahlungsdetektor nach einem vorherigen Anspruch, mit einem Kondensator parallel zur ersten Diode (205A), wobei der Kondensator zur Knotenkapazität der ersten Diode (205A) beiträgt, wobei der Kondensator Polysilicium beinhaltet.

5. Strahlungsdetektor nach einem vorherigen Anspruch, wobei das Pixel ferner eine dritte Diode (205C) umfasst, wobei
die dritte Diode (205C) eine kleinere Knotenkapazität hat als die zweite Diode (205B),
und eine dritte Vorspannungsverdrahtung zum Anlegen einer dritten Vorspannung (VRSTC) an die dritte Diode (205C) zum Zurücksetzen der dritten Diode (205C), wobei die dritte Vorspannung (VRSTC) größer ist als die zweite Vorspannung (VRSTB); und
die Schaltkomponenten die Aufgabe haben, das Ablesen der dritten Diode unabhängig von jeder der ersten und zweiten Dioden (205A, 205B) zuzulassen.

6. Strahlungsdetektor nach Anspruch 5, wobei:
das Pixel mehrere dritte Dioden beinhaltet,
die zweite Diode eine höhere Knotenkapazität hat als jede der dritten Dioden, und
die Schaltkomponenten die Aufgabe haben, das Ablesen von jeder der ersten und zweiten Dioden unabhängig von jeder der dritten Dioden und das Ablesen von jeder der dritten Dioden unabhängig von jeder der ersten und zweiten Dioden und der anderen dritten Diode oder Dioden zuzulassen.

7. Verfahren zum Erkennen von Strahlung, wobei das Verfahren Folgendes beinhaltet:
Bereitstellen des Strahlungsdetektors nach einem vorherigen Anspruch, und
Erkennen von Strahlung mit dem Strahlungsdetektor, wobei das Verfahren ferner Folgendes beinhaltet: Anlegen einer Vorspannung (VRSTA) an die erste Diode (205A) zum Zurücksetzen der ersten Diode (205A) und Anlegen einer Vorspannung (VRSTB) an die zweite Diode (205B) zum Zurücksetzen der zweiten Diode (205B), wobei das Sammeln von strahlungserzeugten Trägern durch die erste Diode (205A) und die zweite Diode (205B) nach dem Zurücksetzen der ersten Diode (205A) und der zweiten Diode (205B) beginnt, **dadurch gekennzeichnet, dass** die zweite Vorspannung (VRSTB) größer ist als die erste Vorspannung (VRSTA).

## Revendications

1. Un détecteur de rayonnement comprenant un pixel, le pixel possédant :
une première diode (205A) agencée de façon à recueillir des porteuses générées par rayonnement à partir d'une première zone de recueil,
une deuxième diode (205B) agencée de façon à recueillir des porteuses générées par rayonnement à partir d'une deuxième zone de recueil, où la première diode (205A) possède une capacité de nœud plus élevée que la deuxième diode (205B),
des composants de commutation (220A, 220B) conçus de façon à permettre une lecture indépendante de signaux provenant de la première diode (205A) et de la deuxième diode (205B),
un première câblage de polarisation destiné à l'application d'une première tension de polarisation (VRSTA) à la première diode (205A),
un deuxième câblage de polarisation destiné à l'application d'une deuxième tension de polarisation (VRSTB) à la deuxième diode (205B),
**caractérisé en ce que** la première zone de recueil et la deuxième zone de recueil se chevauchent au moins partiellement ou se chevauchent entièrement, et
les premier et deuxième câblages de polarisation sont agencés de façon à appliquer la première tension de polarisation (VRSTA) de façon à réinitialiser la première diode (205A) et à appliquer la deuxième tension de polarisation (VRSTB) de façon à réinitialiser la deuxième diode (205B), où le recueil de porteuses générées par rayonnement par la première diode (205A) débute après la réinitialisation de la première diode (205A) et le recueil de porteuses générées par rayonnement par la deuxième diode (205B) débute après la réinitialisation de la deuxième diode (205B), où les première et deuxième tensions de polarisation (VRSTA, VRSTB) sont différentes, la deuxième tension de polarisation (VRSTB) étant supérieure à la première tension de polarisation (VRSTA).

2. Le détecteur de rayonnement selon la Revendication 1, où :
le pixel comprend une pluralité de deuxièmes diodes (205B),
la première diode (205A) possède une capacité de nœud plus élevée que celle de chacune des deuxièmes diodes (205B), et
les composants de commutation fonctionnent de façon à permettre une lecture de la première diode (205A) indépendamment de chacune des deuxièmes diodes (205B), et une lecture de chacune des deuxièmes diodes (205B) indépendamment de la première diode (205A) et de l'autre deuxième diode ou des autres deuxièmes diodes (205B).

3. Le détecteur de rayonnement selon la Revendication 2, où le pixel possède plus de deuxièmes diodes (205B) que de premières diodes (205A).

4. Le détecteur de rayonnement selon l'une quelconque des Revendications précédentes, comprenant un condensateur en parallèle avec la première diode (205A), le condensateur contribuant à la capacité de nœud de la première diode (205A), où le condensateur contient du polysilicium.

5. Le détecteur de rayonnement selon l'une quelconque des Revendications précédentes, où le pixel comprend en outre une troisième diode (205C), où
la troisième diode (205C) possède une capacité de nœud plus petite que celle de la deuxième diode (205B),
et un troisième câblage de polarisation destiné à l'application d'une troisième tension de polarisation (VRSTC) à la troisième diode (205C), de façon à réinitialiser la troisième diode (205C), où la troisième tension de polarisation (VRSTC) est supérieure à la deuxième tension de polarisation (VRSTB), et
les composants de commutation sont conçus de façon à permettre une lecture de la troisième diode indépendamment de chacune des premières et deuxièmes diodes (205A, 205B).

6. Le détecteur de rayonnement selon la Revendication 5, où :
le pixel comprend une pluralité de troisièmes diodes,
la deuxième diode possède une capacité de nœud plus élevée que celle de chacune des troisièmes diodes, et
les composants de commutation fonctionnent de façon à permettre une lecture de chacune des premières et deuxièmes diodes indépendamment de chacune des troisièmes diodes, et une lecture de chacune des troisièmes diodes indépendamment de chacune des premières et deuxièmes diodes et de l'autre troisième diode ou des autres troisièmes diodes.

7. Un procédé de détection de rayonnement, le procédé comprenant :
la fourniture du détecteur de rayonnement selon l'une quelconque des Revendications précédentes, et
la détection d'un rayonnement au moyen du détecteur de rayonnement, le procédé comprenant en outre l'application d'une tension de polarisation (VRSTA) à la première diode (205A) de façon à réinitialiser la première diode (205A) et l'application d'une tension de polarisation (VRSTB) à la deuxième diode (205B) de façon à réinitialiser la deuxième diode (205B), où le recueil de porteuses générées par rayonnement par la première diode (205A) et la deuxième diode (205B) débute après la réinitialisation de la première diode (205A) et de la deuxième diode (205B), **caractérisé en ce que** la deuxième tension de polarisation (VRSTB) est supérieure à la première tension de polarisation (VRSTA).
